# EUROPEAN PATENT APPLICATION

(11) **EP 4 593 405 A1**
(43) Date of publication of application: **30.07.2025**
(21) Application number: 23868574.7
(22) Date of filing: 20.09.2023
(51) Int. Cl.: H04N 23/57, H04N 23/55, H04N 23/54, H05K 1/11, H05K 1/14, H05K 1/18

(54) **CAMERA MODULE AND OPTICAL DEVICE**

(30) Priority: 22.09.2022 KR 20220120341
(71) Applicant: LG INNOTEK CO. LTD, Gangseo-gu Seoul 07796 (KR)
(72) Inventor: CHO, Chul Nae, Seoul 07796 (KR)
(74) Representative: Plasseraud IP
(86) International application number: PCT/KR2023/014215
(87) International publication number: WO 2024/063522

(57) **Abstract**

A camera module comprising: a lens holder in which lenses are disposed; a bracket disposed under the lens holder; a printed circuit board disposed at the lower portion of the bracket; and a stiffener disposed under the printed circuit board, wherein the lower surface of the bracket has a leg portion which protrudes further down than other areas so as to be coupled to the upper surface of the stiffener.

## Description

### [Technical Field]

The present embodiment relates to a camera module and an optical device.

### [Background Art]

The content described below only provides background information for the present embodiment and does not describe prior art.

As various types of mobile terminals become more widespread and wireless Internet services become commercialized, consumer demands related to mobile terminals are also diversifying, and various types of additional devices are being installed in mobile terminals.

Among them, a representative one is a camera module that takes pictures or videos of a subject. Meanwhile, recent camera modules are equipped with an auto focus function that automatically adjusts the focus according to the distance to the subject. In addition, a shake correction function is applied to prevent the image from shaking due to the photographer's hand shake.

Meanwhile, various attempts are being made to reduce the size of the devices applied to the camera module for autofocus or image stabilization functions.

### [Detailed Description of the Invention]

### [Technical Subject]

The present embodiment provides a camera module and optical device capable of reducing the size of a product.

### [Technical Solution]

A camera module of the present embodiment comprises: a lens holder in which a lens is disposed; a bracket being disposed under the lens holder; a printed circuit board being disposed at a lower portion of the bracket; and a stiffener being disposed at a lower portion of the printed circuit board, wherein a leg portion being protruded more downward than other regions and coupled to an upper surface of the stiffener is formed.

A metal pad is disposed on an upper surface of the printed circuit board, and a portion of a lower surface of the bracket can be soldered onto the metal pad.

A lower surface of the leg portion can be soldered to an upper surface of the stiffener.

The printed circuit board includes a cavity, and an image sensor facing the lens can be disposed in the cavity.

The bracket is provided with a bobbin being coupled with the lens, a first coil being disposed on the bobbin, and a first magnet being disposed on the outside of the first coil, and the first coil can be electrically connected to the printed circuit board through the metal pad.

The metal pad may be provided in multiple numbers and disposed to face one another.

A side surface of the leg portion may be spaced apart from a side surface of the printed circuit board.

The stiffener may include a first region facing the printed circuit board in an up and down direction, and a second region being disposed outside the first region and coupled with the leg portion.

The width of the second region can be 0.2 mm to 0.3 mm.

An optical device according to the present embodiment comprises: a main body; a camera module being disposed in the main body and photographing an image of a subject; and a display unit being disposed in the main body and outputting an image photographed by the camera module, wherein the camera module comprises: a lens holder in which a lens is disposed; a bracket being disposed at a lower portion of the lens holder; a printed circuit board being disposed at a lower portion of the bracket; and a stiffener being disposed under the printed circuit board, and wherein a lower surface of the bracket has a leg portion being protruded further down than other regions so as to be coupled to an upper surface of the stiffener.

### [Advantageous Effects]

Through the present embodiment, the size of the printed circuit board is reduced to the size of the formation region of the second region, so there is an advantage in that the manufacturing cost can be reduced.

In addition, due to the structure in which the bracket is soldered on the stiffener, there is an advantage in that it is easy to maintain the flatness of the bracket, and the bonding strength among the bracket, printed circuit board, and stiffener can be maintained firmly.

In addition, since the optical axis length of a camera module can be shortened by the thickness of the printed circuit board, there is an advantage in that the camera module can be further miniaturized.

### [Brief Description of Drawings]

FIG. 1 is a cross-sectional view of a camera module according to an embodiment of the present invention.
FIG. 2 is a plan view illustrating the upper surface of a printed circuit board according to an embodiment of the present invention.
FIG. 3 is a modified embodiment of a camera module according to an embodiment of the present invention.
FIG. 4 is a perspective view of an optical device according to an embodiment of the present invention.

### [BEST MODE]

Hereinafter, preferred embodiments of the present invention will be described in detail with reference to the accompanying drawings.

However, the technical idea of the present invention is not limited to some embodiments to be described, but may be implemented in various forms, and inside the scope of the technical idea of the present invention, one or more of the constituent elements may be selectively combined or substituted between embodiments.

In addition, the terms (including technical and scientific terms) used in the embodiments of the present invention, unless explicitly defined and described, can be interpreted as a meaning that can be generally understood by a person skilled in the art, and commonly used terms such as terms defined in the dictionary may be interpreted in consideration of the meaning of the context of the related technology.

In addition, terms used in the present specification are for describing embodiments and are not intended to limit the present invention.

In the present specification, the singular form may include the plural form unless specifically stated in the phrase, and when described as "at least one (or more than one) of A and B and C", it may include one or more of all combinations that can be combined with A, B, and C.

In addition, in describing the components of the embodiment of the present invention, terms such as first, second, A, B, (a), and (b) may be used. These terms are merely intended to distinguish the components from other components, and the terms do not limit the nature, order or sequence of the components.

And, when a component is described as being 'connected', 'coupled' or 'interconnected' to another component, the component is not only directly connected, coupled or interconnected to the other component, but may also include cases of being 'connected', 'coupled', or 'interconnected' due that another component between that other components.

In addition, when described as being formed or disposed in "on (above)" or "below (under)" of each component, "on (above)" or "below (under)" means that it includes not only the case where the two components are directly in contact with, but also the case where one or more other components are formed or disposed between the two components. In addition, when expressed as "on (above)" or "below (under)", the meaning of not only an upward direction but also a downward direction with respect to one component may be included.

The 'optical axis direction' used below is defined as the optical axis direction of the lens coupled to the camera module. Meanwhile, an 'optical axis direction' can correspond to an 'up and down direction', a 'z-axis direction', and the like.

The 'auto focus function' used below is defined as a function that automatically focuses on a subject by adjusting the distance from the image sensor by moving the lens module in an optical axis direction according to the distance to the subject so that a clear image of the subject can be obtained on an image sensor. Meanwhile, 'auto focus' can be used interchangeably with ' auto focus (AF)'.

The 'hand shake correction function' used below is defined as a function that moves or tilts the lens module in a direction perpendicular to the optical axis direction to offset vibration (movement) caused to the image sensor by external force. Meanwhile, the 'hand shake correction' may be used interchangeably with ' optical image stabilization (OIS)'.

Hereinafter, the present invention will be described in more detail with reference to the attached drawings.

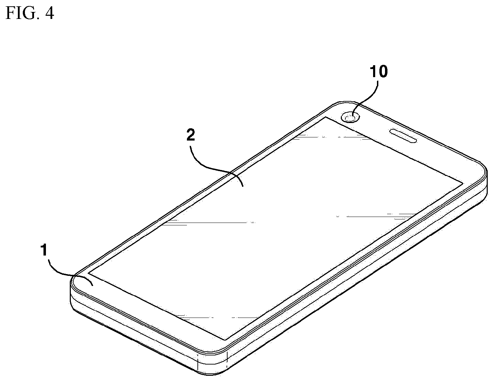

FIG. 4 is a perspective view of an optical device according to an embodiment of the present invention.

The optical device may be any one among a mobile phone, a cellular phone, a smart phone, a portable smart device, a digital camera, a laptop computer, a digital broadcasting terminal, a personal digital assistant (PDA), a portable multimedia player (PMP), and a navigation device. However, the type of the optical device is not limited thereto, and any device for photographing images or pictures may be referred to as an optical device.

An optical device may include a main body **1,** a display unit **2,** and a camera module **10.** However, in the optical device, any one or more among the main body **1,** the display unit **2,** and the camera module **10** may be omitted or changed.

The main body **1** may form an outer appearance of an optical device. As an example, the main body **1** may have a rectangular parallelepiped shape. As another example, the main body **1** may be rounded in at least in a portion. The main body **1** may accommodate the camera module **10.** The display unit **2** may be disposed on one surface of the main body **1.** As an example, the display unit **2** and the camera module **10** may be disposed on one surface of the main body **1,** and the camera module **10** may be additionally disposed on the other surface (a surface located opposite to one surface) of the main body **1.**

The display unit **2** may be disposed on the main body **1.** The display unit **2** may be disposed on one surface of the main body **1.** That is, the display unit **2** may be disposed on the same surface as the camera module **10.** Alternatively, the display unit **2** may be disposed on the other surface of the main body **1.** The display unit **2** may be disposed on the surface opposite to the surface on which the camera module **10** is disposed on the main body **1.** The display unit **2** may output an image photographed by the camera module **10.**

The camera module **10** may be disposed on the main body **1.** The camera module **10** may be disposed on one surface of the main body **1.** At least a portion of the camera module **10** may be accommodated inside the main body **1.** A plurality of camera modules **10** may be provided. A plurality of camera modules **10** may be disposed on one surface of the main body **1** and the other surface of the main body **1.** The camera module **10** may photograph an image of a subject.

Hereinafter, a configuration of a camera module according to the present embodiment will be described with reference to the drawings.

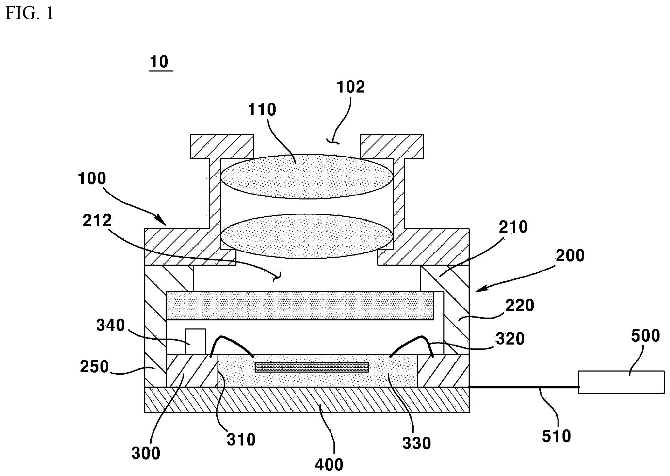

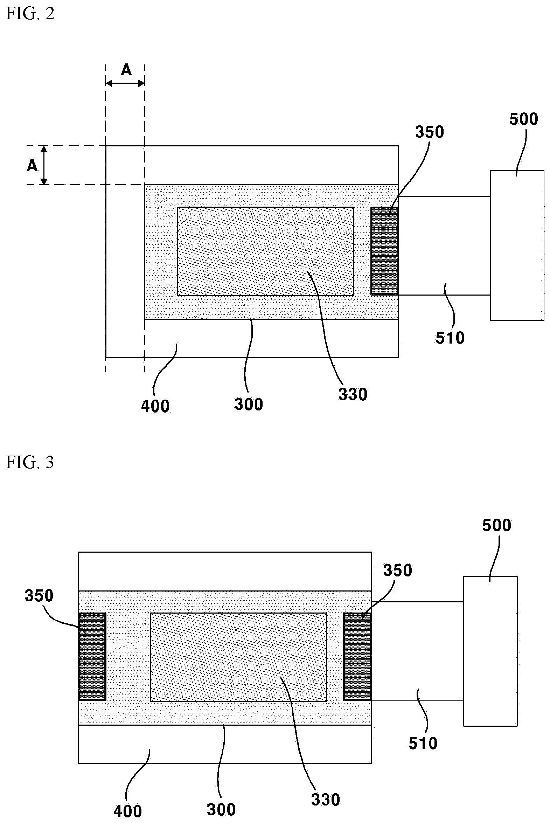

FIG. 1 is a cross-sectional view of a camera module according to an embodiment of the present invention; and FIG. 2 is a plan view illustrating the upper surface of a printed circuit board according to an embodiment of the present invention.

Referring to FIGS. 1 and 2, a camera module **10** according to an embodiment of the present invention may comprise a lens holder **100,** a bracket **200,** a printed circuit board **300,** and a stiffener **400.** However, in the camera module **10,** any one or more among the lens holder **100,** the bracket **200,** the printed circuit board **300,** and the stiffener **400** may be omitted or changed.

The lens holder **100** may accommodate at least one or more lens **110** inside. A space for accommodating the lens **110** may be formed in the lens holder **100.** A hole **102** opening the space may be formed on the upper and lower surfaces of the lens holder **100,** and the lens **110** may be exposed in an optical axis direction through the hole.

The lens holder **100** may be referred to as a lens barrel in that the lens **110** is accommodated inside.

The lens **110** may be disposed in a space inside the lens holder **100.** The lens **110** may be screw-coupled inside the space. There may be at least one or more lens **110.** For example, a plurality of lenses **110** may be provided and may be disposed to be spaced apart from one another in an optical axis direction inside the space. A spacer (not shown) may be disposed between pluralities of lenses.

The lens **110** may be aligned with an image sensor **330** to be described later. The lens **110** may be optically aligned with the image sensor **330.** An optical axis of the lens **110** may correspond to an optical axis of the image sensor **330.**

The bracket **200** may be disposed at a lower portion of the lens holder **100.** An upper surface of the bracket **200** may be coupled to a lower surface of the lens holder **100.** The bracket **200** may have a rectangular cross-sectional shape. A hole **212** may be formed in an upper surface of the bracket **200** being overlapped with the lens **110** in an optical axis direction. The lens **110** and the image sensor **330** may be optically aligned through the hole **212.**

The bracket **200** may include an upper plate **210** and a side plate **220.** The upper plate **210** may form an upper surface of the bracket **200.** An upper surface of the upper plate **210** may be coupled to a lower surface of the lens holder **100.** The hole **212** may be formed at the center of the upper plate **210.**

The side plate **220** may form a side surface of the bracket **200.** The side plate **220** may be formed to be bent from an edge region of the upper plate **210** and extended downward. The side plate **220** may be disposed perpendicular to the upper plate **210.** Two or more step regions having different heights may be formed at the lower end of the side plate **220.**

An infrared ray filter **230** may be disposed between the lens **110** and the image sensor **330.** The infrared filter **230** may be disposed in a space inside the bracket **200.** The infrared filter **230** may be coupled to a lower surface of the upper plate **210.**

An actuator (not shown) for moving the lens **110** to perform an optical function may be provided in the bracket **200.** Through the actuator, the camera module **10** may perform an auto-focusing (AF) function, hand shake correction and an optical image stabilizer (OIS) function, and the like.

The actuator may include a housing, a bobbin being disposed inside the housing to which the lens **110** is coupled, a coil being disposed on an outer circumferential surface of the bobbin, and a first magnet being disposed in the housing and facing the coil. In addition, the actuator may include an elastic member being coupled to the housing and the bobbin. Accordingly, by the electromagnetic interaction between the coil and the magnet, the bobbin may rotate together with the lens **110.**

Meanwhile, the coil may include a first coil for an auto-focusing function and a second coil for a hand shake correction function. In this case, a second magnet facing the second coil may be additionally provided on an outer side of the second coil. Accordingly, the bobbin may move in an optical axis direction by the electromagnetic interaction between the first coil and the first magnet, and the bobbin may move in a direction perpendicular to the optical axis direction by the electromagnetic interaction between the second coil and the second magnet.

The above first coil and the above second coil can be electrically connected to the printed circuit board **300.**

The printed circuit board **300** may be disposed at a lower portion of the bracket **200.** The printed circuit board **300** is formed in a plate shape, and at least one electronic component for driving the camera module **10** may be disposed on an upper surface thereof. For example, the electronic component may include a capacitor **340.**

The printed circuit board **300** may have a rectangular cross-sectional shape. The printed circuit board **300** may include a first side, a second side being disposed to face the first side, a third side being disposed adjacent to the first side and the second side, and a fourth side being disposed to face the third side and adjacent to the first side and the second side. The lengths of the first side and the second side may be formed to be smaller than the lengths of the third side and the fourth side.

The printed circuit board **300** may include a cavity **310.** The cavity **310** may have a hole shape penetrating from an upper surface to a lower surface of the printed circuit board **300.** The cavity **310** may have a groove shape being formed to be recessed further downward from the upper surface of the printed circuit board **300** than other regions. The cavity **310** may be disposed at a center of the printed circuit board **300.** The cross-sectional shape of the cavity **310** may be formed to correspond to the cross-sectional shape of the image sensor **330.**

An image sensor **330** may be disposed in the cavity **310.** The image sensor **330** may be disposed to face the lens **110** in an optical axis direction. The upper surface of the image sensor **330** may be disposed to form the same plane as the upper surface of the printed circuit board **300.**

The image sensor **330** may be electrically coupled to the printed circuit board **300** through a wire **320.** One end of the wire **320** is coupled on to the image sensor **330** and the other end may be coupled on to the printed circuit board **300.** A plurality of wires **320** may be provided and disposed to be spaced apart from one another

A metal pad **350** may be disposed on an upper surface of the printed circuit board **300.** The metal pad **350** may be a region in which the circuit pattern in the printed circuit board **300** is exposed upward. The metal pad **350** may be formed of a metal material. The metal pad **350** may be disposed adjacent to the second side. A lower end of the bracket **200** may be coupled to the metal pad **350.** A portion of a lower end of the bracket **200** may be coupled to the metal pad **350** by welding.

By the coupling of the bracket **200** and the metal pad **350,** the first coil inside the bracket **200** can be electrically connected to the printed circuit board **300.**

The camera module **10** may include a sub-substrate **500.** The sub-substrate **500** may be electrically connected to the printed circuit board **300** through an FPCB **510.** The sub-substrate **500** may be disposed outside the printed circuit board **300.** An external connector electrically connected to an external power source or other devices may be disposed on the sub-substrate **500.** One end of the FPCB **510** for connection with the sub-substrate **500** may be coupled to the second side of the printed circuit board **300** on which the metal pad **350** is disposed. One end of the FPCB **510** may be soldered to the metal pad **350** together with the bracket **200.**

The stiffener **400** may be disposed on a lower surface of the printed circuit board **300.** The stiffener **400** may be formed in a plate shape. The stiffener **400** may be formed of a metal material. An upper surface of the stiffener **400** may support a lower surface of the printed circuit board **300** and a lower surface of the image sensor **330.** The rigidity of the printed circuit board **300** to which the image sensor **330** is coupled may be enhanced through the stiffener **400.**

The stiffener **400** may have a rectangular cross-sectional shape. The cross-sectional area of the stiffener **400** may be larger than the cross-sectional area of the printed circuit board **300.**

The above stiffener **400** may include a first region disposed to be overlapped with the printed circuit board **300** in the up and down directions, and a second region disposed on the outside of the first region. The second region may be disposed so as not to be overlapped with the printed circuit board **330.** As illustrated in FIG. 2, the second region may have a cross-section having an approximately "c" shape. The second region may be disposed on the outside of the first side, the third side, and the fourth side of the printed circuit board **300.**

The width **A** of the second region may be 0.2 mm to 0.3 mm.

The bracket **200** may include a leg region **250.** The leg region **250** may have a shape being protruded downward from the lower surface of the bracket **200** than other regions. That is, the leg region **250** may have a shape being extended downward from the side plate **220.** The leg region **250** may be disposed to be overlapped with the printed circuit board **300** in a direction perpendicular to the optical axis direction. The leg region **250** may be disposed to be overlapped with the second region of the stiffener **400** in an optical axis direction. The lower surface of the leg region **250** may be coupled to the upper surface of the stiffener **400.** The lower surface of the leg region **250** may be coupled to the upper surface of the stiffener **400.** The lower surface of the leg region **250** may be soldered to the upper surface of the stiffener **400.** The cross-sectional shape of the leg region **250** may be formed to correspond to the cross-sectional shape of the second region.

The leg region **250** may be disposed outside the first side, the third side, and the fourth side of the printed circuit board **300.** Specifically, when the cross section of the bracket **200** is formed in a rectangular shape, the bracket **200** may include a fifth side where the leg region **250** is formed, a sixth side and a seventh side, which are adjacent to the fifth side and are similarly formed with the leg portion, and an eighth side being disposed to face the fifth side and soldered on the metal pad **350.** The lower surfaces of the fifth side, the sixth side, and the seventh side, which are formed at a lower end of the leg region **250,** may be disposed at a lower side than the lower surface of the eighth side.

The side surface of the leg portion **250** may be spaced apart from the side surface of the printed circuit board **300.** Unlike this, the side surface of the leg portion **250** may be in contact with the side surface of the printed circuit board **300.**

According to the above structure, the size of the printed circuit board is reduced by the size of the second region forming region, so there is an advantage in that the manufacturing cost can be lowered.

In addition, there is an advantage in that since the bracket is soldered on the stiffener, it is easy to maintain the flatness of the bracket, and the bonding strength between the bracket, printed circuit board, and stiffener can be maintained firmly.

In addition, since the optical axis direction length of the camera module can be shortened by the thickness of the printed circuit board, there is an advantage in that the camera module can be more miniaturized.

FIG. 3 is a modified embodiment of a camera module according to an embodiment of the present invention.

Referring to FIG. 3, in the present modified embodiment, since a plurality of metal pads **350** are provided on the printed circuit board **300,** there is a difference in the shape of the printed circuit board **300** and the arrangement structure with the stiffener **400.**

Specifically, in the present modified embodiment, a plurality of metal pads **350** is provided to be adjacent to the first side and the second side of the printed circuit board **300,** and the second region of the stiffener **400** may be disposed outside the third side and the fourth side of the printed circuit board **300.**

Accordingly, the leg portion **250** is formed only on the sixth and seventh sides of the bracket **200,** and lower surfaces of the fifth and eighth sides may be soldered onto the plurality of metal pads **350** respectively.

In the present modified embodiment, by a plurality of bonding regions between the bracket **200** and the printed circuit board **300,** any one among the plurality of metal pads **350** can be electrically connected to a first coil for the AF function, and the other one can be electrically connected to a second coil for the OIS function.

In the above description, it is described that all the components constituting the embodiments of the present invention are combined or operated in one, but the present invention is not necessarily limited to these embodiments. In other words, within the scope of the present invention, all of the components may be selectively operated in combination with one or more. In addition, the terms "comprise", "include" or "having" described above mean that the corresponding component may be inherent unless specifically stated otherwise, and thus it should be construed that it does not exclude other components, but further include other components instead. All terms, including technical and scientific terms, have the same meaning as commonly understood by one of ordinary skill in the art unless otherwise defined. Terms used generally, such as terms defined in a dictionary, should be interpreted to coincide with the contextual meaning of the related art, and shall not be interpreted in an ideal or excessively formal sense unless explicitly defined in the present invention.

The above description is merely illustrative of the technical idea of the present invention, and those skilled in the art to which the present invention pertains may make various modifications and changes without departing from the essential characteristics of the present invention. Therefore, the embodiments disclosed in the present invention are not intended to limit the technical idea of the present invention but to describe the present invention, and the scope of the technical idea of the present invention is not limited by these embodiments. The protection scope of the present invention should be interpreted by the following claims, and all technical ideas within the equivalent scope should be interpreted as being included in the scope of the present invention.

## Claims

1. A camera module comprising:
a lens holder in which a lens is disposed;
a bracket disposed under the lens holder;
a printed circuit board disposed at a lower portion of the bracket; and
a stiffener disposed at a lower portion of the printed circuit board,
wherein a leg portion protruded more downward than other regions and coupled to an upper surface of the stiffener is formed.

2. The camera module according to claim 1,
wherein a metal pad is disposed on an upper surface of the printed circuit board, and
wherein a portion of a lower surface of the bracket can be soldered onto the metal pad.

3. The camera module according to claim 1,
wherein a lower surface of the leg portion is soldered to an upper surface of the stiffener.

4. The camera module according to claim 1,
wherein the printed circuit board includes a cavity, and
wherein an image sensor facing the lens is disposed in the cavity.

5. The camera module according to claim 2,
wherein the bracket is provided with a bobbin being coupled with the lens, a first coil disposed on the bobbin, and
wherein a first magnet disposed on the outside of the first coil, and the first coil can be electrically connected to the printed circuit board through the metal pad.

6. The camera module according to claim 2,
wherein the metal pad is provided in multiple numbers and disposed to face one another.

7. The camera module according to claim 1,
wherein a side surface of the leg portion is spaced apart from a side surface of the printed circuit board.

8. The camera module according to claim 1,
wherein the stiffener includes a first region facing the printed circuit board in an up and down direction, and a second region disposed outside the first region and coupled with the leg portion.

9. The camera module according to claim 8,
wherein the width of the second region is 0.2 mm to 0.3 mm.

10. An optical device comprising:
a main body; a camera module disposed in the main body and photographing an image of a subject; and a display unit disposed in the main body and outputting an image photographed by the camera module,
wherein the camera module comprises:
a lens holder in which a lens is disposed;
a bracket disposed at a lower portion of the lens holder;
a printed circuit board disposed at a lower portion of the bracket; and
a stiffener disposed under the printed circuit board, and
wherein a lower surface of the bracket has a leg portion protruded further down than other regions so as to be coupled to an upper surface of the stiffener.
